# FASCICULE DE BREVET EUROPEEN

(11) **EP 2 690 655 B1**
(45) Date de publication et mention de la délivrance du brevet: **08.08.2018**
(21) Numéro de dépôt: 13176415.1
(22) Date de dépôt: 12.07.2013
(51) Int. Cl.: H01L 21/768, H01L 23/48

(54) **Procédé de réalisation de vias**
Verfahren zur Herstellung von Durchkontaktierungen
Method for making via holes

(30) Priorité: 25.07.2012 FR 1257226
(43) Date de publication de la demande: 29.01.2014
(73) Titulaire: COMMISSARIAT À L'ÉNERGIE ATOMIQUE ET AUX ÉNERGIES ALTERNATIVES, 75015 Paris (FR)
(72) Inventeur: Chausse, Pascal, 38170 SEYSSINET PARISET (FR)
(74) Mandataire: Decobert, Jean-Pascal

(56) Documents cités:
- EP-A1- 1 998 371
- FR-A1- 2 901 635
- US-A1- 2005 224 921
- US-A1- 2009 294 983
- US-A1- 2012 133 048

## Description

### DOMAINE TECHNIQUE DE L'INVENTION

La présente invention concerne en général l'assemblage tridimensionnel (3D) de puces électroniques et plus particulièrement la formation de vias traversants et la redistribution des signaux entre les puces d'un empilement 3D de puces.

### ÉTAT DE LA TECHNIQUE

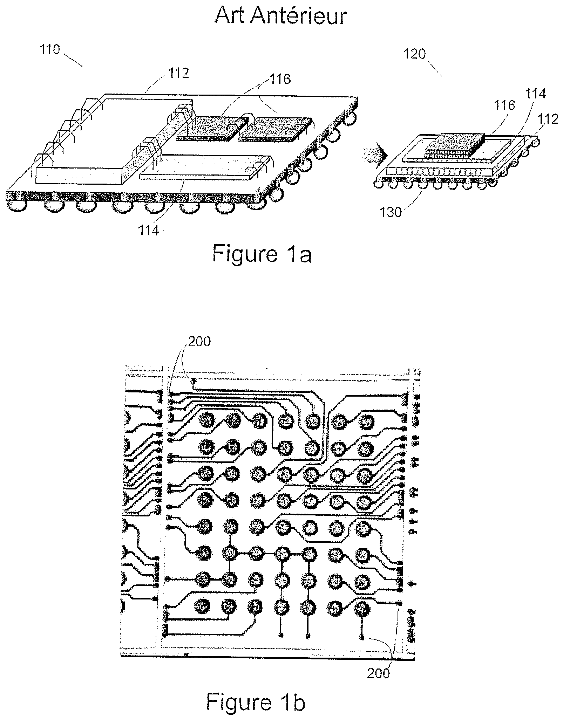

Comme illustré sur la figure 1a, les dispositifs produits par l'industrie de la microélectronique, qu'ils soient purement électroniques comme les circuits intégrés (ou IC de l'anglais « integrated circuit ») ou qu'ils constituent des microsystèmes électromécaniques (ou MEMS de l'anglais « micro electro mechanical system »), sont de plus en plus souvent assemblés, non plus en les disposant les uns à côté des autres dans un boîtier plan 110 comme cela a été longtemps le cas, mais en les empilant les uns sur les autres dans un boîtier 3D 120. Il s'agit typiquement, comme représenté, d'un boîtier de type BGA, acronyme de l'anglais « bail grid array » où les interconnexions avec l'extérieur se font par l'intermédiaire d'une « matrice de billes » 130. Outre le fait qu'on obtient ainsi une réduction significative de l'encombrement, les boîtiers 3D permettent aussi de beaucoup réduire la longueur des lignes d'interconnexion entre puces. Ce qui se traduit par un gain en performance et/ou une réduction de la consommation électrique. Ces améliorations, combinées avec une réduction des coûts de fabrication obtenue grâce à une automatisation plus poussée permise par ce type de montage, font que les assemblages 3D voient leur emploi se généraliser et leur champ d'application s'élargir.

L'interconnexion verticale des puces et la redistribution des signaux électriques d'interconnexion entre niveaux ne manquent cependant pas de poser des problèmes propres à ce mode d'assemblage. Il faut en effet avoir recours à des « vias traversants », généralement désignés par l'acronyme TSV de l'anglais « through silicon via » qui, comme le nom le suggère, sont conçus pour traverser complètement les puces, généralement faites de silicium.

Les TSVs permettent de relier les signaux électriques depuis la face active d'une puce électronique, celle où les circuits ont été fabriqués en surface et qui est communément appelée « face avant », vers sa face opposée, communément appelée « face arrière ». Comme montré dans l'exemple de la figure 1b, ces signaux sont ensuite répartis, sur la face arrière de chaque puce, à l'aide d'une couche de redistribution ou RDL, acronyme de l'anglais « redistribution layer ». Le rôle essentiel de cette couche est de relier électriquement chacun des TSVs 200, généralement placés à la périphérie de la puce à assembler, à une plage d'accueil spécifique afin de pouvoir acheminer le signal correspondant à l'extérieur du boîtier protégeant les puces.

Le document US2009 /294 983 décrit un exemple de TSV reliant les deux faces d'une puce électronique. Les vias traversants ou TSVs sont dans certains cas réalisés en dernier selon une méthode dite « via last » après que les puces ont été fabriquées. Typiquement, il s'agit en effet d'assembler dans un boîtier des puces provenant de technologies différentes comme montré dans la figure 1a où l'on veut, par exemple, pouvoir empiler une puce mémoire 112, une puce logique 114 et des circuits passifs 116.

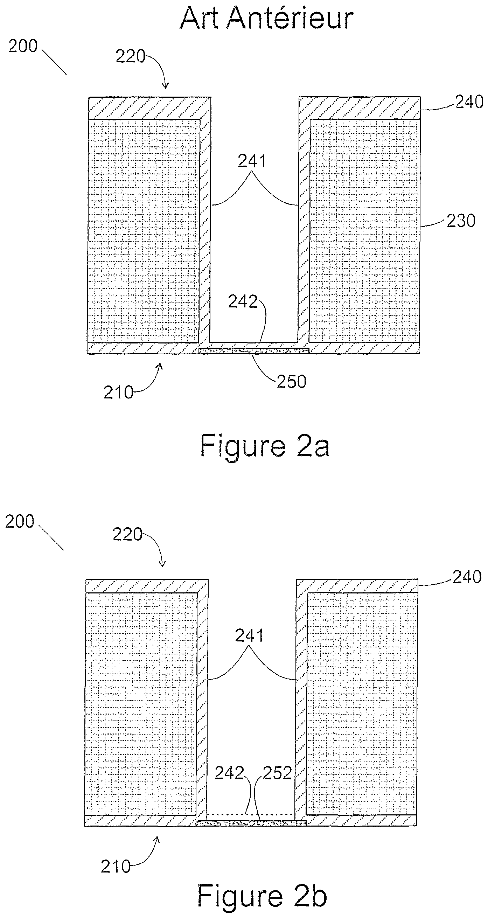

La réalisation des vias traversants et du niveau de redistribution se fait actuellement, par la méthode « via last », selon un procédé qui est décrit ci-après dans les figures 2a à 2h. A l'issue de ce procédé conventionnel, on obtient un via qui est typiquement de grande profondeur, avec un rapport de forme (aussi appelé en anglais « aspect ratio ») potentiellement élevé, et partiellement empli d'un matériau conducteur tel du cuivre. Le remplissage n'est que partiel car un remplissage complet impliquerait une très grande consommation de matières à déposer, les dépôts étant dans ce contexte des dépôts pleine plaque. Outre qu'il s'agit d'un procédé qui comporte un grand nombre d'étapes, la surface du niveau de distribution obtenue n'est pas, comme on va le voir, plane. L'assemblage de puces toujours plus denses augmentant la densité des interconnexions verticales, leur redistribution horizontale peut demander de devoir disposer de plusieurs niveaux de redistribution et d'une meilleure définition sur chacun des niveaux. Ceci est cependant difficilement compatible avec la technologie actuelle.

C'est donc un objet de l'invention que de décrire un procédé amélioré de formation des vias traversants et de la couche de redistribution qui pallie au moins en partie les inconvénients du procédé standard.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Un aspect de l'invention est relatif à un procédé de réalisation d'au moins un via dans l'épaisseur d'un substrat et d'une ligne électriquement conductrice raccordée au via et formée sur une face du substrat, ledit procédé comportant :
- formation, à partir de la face, d'une cavité de via comportant une paroi latérale et un fond;
- formation d'une couche d'isolant sur la paroi latérale et le fond de la cavité et sur la face du substrat ;
- formation d'au moins un motif de ligne sur la face du substrat, comprenant la formation d'une tranchée dans une portion seulement de la couche d'isolant située sur la face, la tranchée débouchant dans la cavité de via;
- remplissage, par un matériau électriquement conducteur, à la fois du motif de ligne et de la cavité du via, remplissage configuré pour ne pas remplir totalement ladite cavité;

Alors que les technique actuelles préjugent du caractère distinct et successif des étapes liées à la formation des motifs de ligne RDL et des étapes liées à la formation des éléments du via, l'invention combine des phases de fabrication en associant intimement la définition des motifs de ligne et du via par la création de tranchées directement dans la couche d'isolant. Grâce à l'invention, les motifs comprennent des tranchées qui sont des parties en creux relativement à la surface du substrat, les lignes de redistribution présentant ainsi, après remplissage des motifs, des canaux en deçà de la surface supérieure de la face du substrat.

Le remplissage du motif de ligne et la cavité de via est avantageusement simultané grâce à l'invention, c'est-à-dire dans une phase commune. Le remplissage peut comprendre plusieurs étapes faites à la fois pour le motif de ligne et pour la cavité de via.

Un autre aspect de l'invention est un dispositif électronique comportant un substrat et au moins un via et une ligne conductrice.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a et 1b illustrent un exemple d'assemblage tridimensionnel (3D) de puces.
Les FIGURES 2a à 2h et 3h illustrent les étapes du procédé standard de formation des vias traversants (TSV) et du niveau de redistribution (RDL) des interconnexions verticales.
Les FIGURE 3a à 3g et 3i illustrent les étapes du procédé amélioré de l'invention qui permet notamment d'obtenir une surface plane du niveau de redistribution et une meilleure définition.

Les dessins joints sont donnés à titre d'exemples et ne sont pas limitatifs de l'invention.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
- la formation d'une tranchée est opérée par gravure simultanément à un retrait par ladite gravure de la portion de la couche d'isolant située sur le fond de la cavité.
- la gravure est précédée d'une étape de photolithographie configurée pour délimiter un motif de tranchée.
- le remplissage a une épaisseur au moins égale à une dimension en profondeur de la tranchée.
- il comprend, après remplissage, un amincissement par la face du substrat jusqu'à faire disparaître le matériau électriquement conducteur en dehors de la tranchée.
- l'amincissement est opéré par polissage mécano chimique.
- le remplissage est effectué en deux étapes comportant une première étape de dépôt d'un fond continu conducteur et une seconde étape de croissance électrolytique configurée pour remplir la au moins une tranchée sans remplir totalement la cavité de via.
- le remplissage est suivi par une étape de dépôt d'une couche de passivation.
- la couche de passivation est en un matériau diélectrique.
- le dépôt d'une couche de passivation est opéré de sorte à remplir intégralement la cavité de via .
- la couche de passivation est en un matériau polymère et le dépôt de la couche de passivation est opéré sur la face du substrat de sorte à fermer l'embouchure de la tranchée débouchant sur la face sans remplir la cavité de via. Le polymère ne rentre alorspas dans le via et le ferme en le couvrant comme un opercule.
- le rapport de forme de la plus grande dimension de la section du via relativement à sa profondeur jusqu'à la tranchée est compris entre 0.1 et 10.
- la tranchée présente une première embouchure débouchant dans la cavité de via et une deuxième embouchure débouchant sur la face, la deuxième embouchure étant plus grande que la première embouchure.

A moins que le contexte n'implique une interprétation différente, les termes « épaisseur » et « profondeur » s'entendent, dans la présente demande, de dimensions orientées suivant l'épaisseur du substrat, entre ses deux faces avant et arrière.

Les termes du type « disposé sur » ou « au dessus » ne signifient pas systématiquement un contact direct mais, a priori, toute disposition où une superposition est effective. Cela inclut la présence de couches intercalaires entre les parties superposées.

Lorsque l'on réalise les vias traversants en dernier selon la méthode dite « via last » mentionnée précédemment le diamètre des TSVs est typiquement compris dans une gamme de valeurs allant de 20 µm (µm = 10⁻⁶ mètre) à 200 µm. On notera ici qu'on n'essaye pas de remplir entièrement le trou traversant à l'aide d'un conducteur métallique, généralement du cuivre, principalement pour des raisons de coût. Le dépôt par électrolyse se faisant préférentiellement en surface, le temps de dépôt requis pour remplir intégralement les vias serait de plusieurs heures. Le dépôt en surface étant nettement plus important qu'au fond des trous il faudrait déposer beaucoup de cuivre pour remplir les vias. Par exemple, pour 5 µm déposés en surface d'un TSV d'un diamètre de 40 µm ayant un rapport de forme de 1 pour 3 (rapport diamètre/épaisseur), seulement 0,8 µm est effectivement déposé au fond. Le remplissage des TSVs implique qu'il faudrait ensuite procéder à un retrait mécano chimique du surplus métallique en surface ce qui serait une opération longue et très coûteuse. Par ailleurs la masse de cuivre déposée créerait des contraintes mécaniques dans les matériaux lors des différents traitements thermiques liés au procédé de fabrication et pourrait induire en se dilatant des dislocations dans le silicium environnant.

On procède donc à une simple métallisation des flancs du via, à l'aide d'une couche conductrice de quelques microns d'épaisseur déposée, par exemple, à l'aide d'un procédé électrolytique. Cette métallisation de l'intérieur du via permet de réaliser simultanément celle des lignes du niveau RDL, suivant la série d'étapes décrite dans les figures suivantes.
Les **figures 2a à 2h** illustrent les étapes du procédé standard de formation des vias traversants (TSVs) et du niveau de redistribution (RDL) des interconnexions verticales entre puces.
La figure 2a montre l'état initial d'un TSV 200 en cours de fabrication.
On notera tout d'abord que dans cette figure, et dans toutes celles qui suivent, la face dite «face avant» 210, celle à partir de laquelle les composants fonctionnels d'une puce ont été fabriqués, est représentée comme étant la face inférieure du schéma du TSV. La face dite « face arrière » 220 est représentée comme étant la face supérieure du TSV.

À ce stade, le TSV 200 a été gravé à travers toute l'épaisseur de la puce 230 et on a déposé une couche d'isolant 240 qui assure l'isolation électrique notamment entre les flancs 241 du TSV et le matériau semi-conducteur constituant le substrat de la puce, généralement du silicium. Les vias sont gravés en regard de plages métalliques 250 qui ont été formées en même temps que les interconnexions des composants réalisés sur la face avant 210 de la puce lors des opérations dites de « fin de ligne » de fabrication généralement désignées par l'acronyme BEOL de l'anglais « back-end of line » où l'on réalise l'interconnexion des composants d'une puce.

La figure 2b montre le résultat de la gravure de la partie de l'isolant constituant la couche 240 qui est située au fond 242 des vias. Cette opération de gravure est très anisotrope de façon à graver préférentiellement le fond 242 plutôt que les flancs 241 du via jusqu'à mettre à nu 252 le métal de la plage 250 pour permettre une bonne reprise de contact électrique sur celle-ci, sans mettre à nu les flancs 241. La gravure est préférentiellement de type plasma ou usinage ionique. On notera qu'au cours de cette opération la couche d'oxyde 240 de la face arrière 210 est gravée au moins autant que le fond des vias.

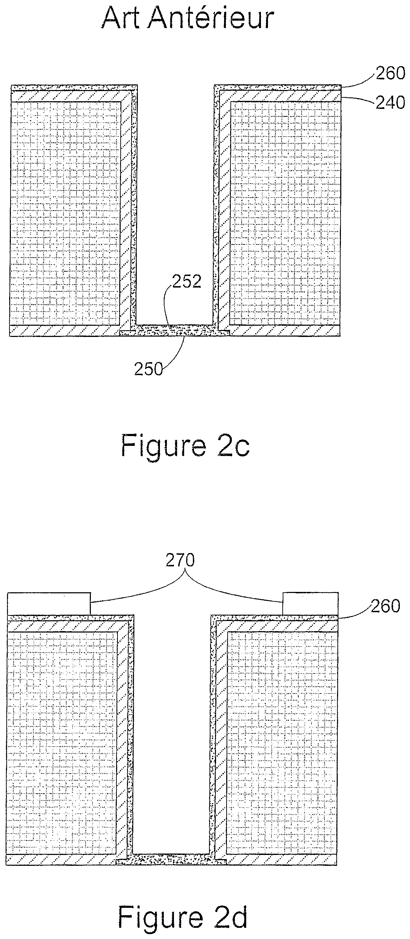

La figure 2c montre l'étape suivante où l'on vient déposer une couche continue conductrice métallique 260, généralement du cuivre. Le dépôt de cette couche se fait préférentiellement par dépôt physique ou chimique en phase vapeur, méthodes de dépôt respectivement désignées par les acronymes PVD et CVD, de l'anglais « physical vapor déposition » et « chemical vapor deposition ». D'autres méthodes de dépôt sont susceptibles d'être utilisées.

Le dépôt de la couche 260 peut-être précédé, (suivant la nature et la compatibilité de la couche 260 avec la couche isolante) du dépôt d'une couche d'accrochage (non représentée) et d'une couche (non représentée) faisant barrière à la diffusion du cuivre dans le silicium. Il s'agit par exemple de couches de titane et de nitrure de titane (Ti /TiN). Bien entendu, ces deux fonctions (accroche et barrière) auraient pu également être assurées par une seule couche.

À l'issue de cette étape, un bon contact électrique est établi entre la couche 260 et la plage 250 au niveau de l'interface 252.

La figure 2d illustre l'étape où l'on définit sur la face arrière des puces les motifs de cuivre de la couche de redistribution (RDL) à l'aide d'un polymère photosensible qui va constituer la résine de masquage pour l'opération suivante. Les motifs 270 sont définis de façon standard par photolithographie.

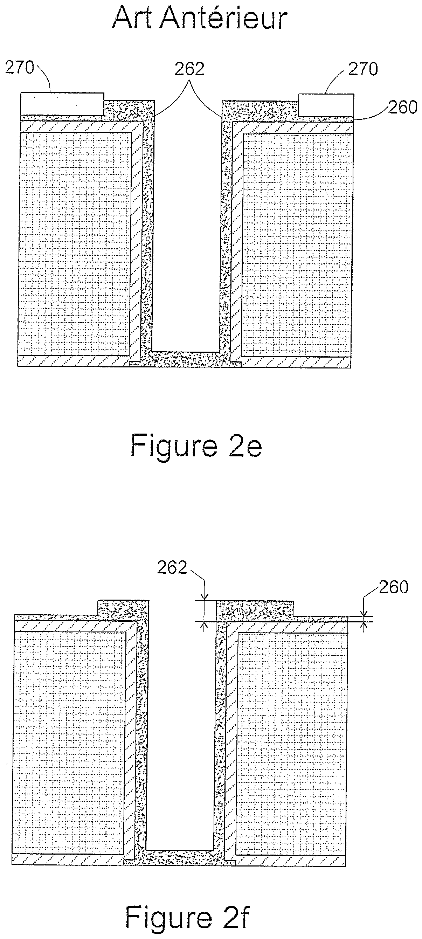

La figure 2e montre le résultat de l'étape de croissance de la couche métallique initiale 260, généralement du cuivre. La croissance est localisée aux zones qui n'ont pas été protégées par la résine 270 à l'étape précédente. La croissance se fait préférentiellement par voie électrolytique. On obtient ainsi une couche épaissie 262.

La figure 2f illustre l'étape où l'on procède au retrait de la résine de masquage. Le retrait de la résine laisse en place sur la face arrière une couche continue de cuivre de deux épaisseurs différentes, l'une correspondant à la couche initiale 260, l'autre à la couche épaissie 262 définissant les motifs de la couche de redistribution (RDL).

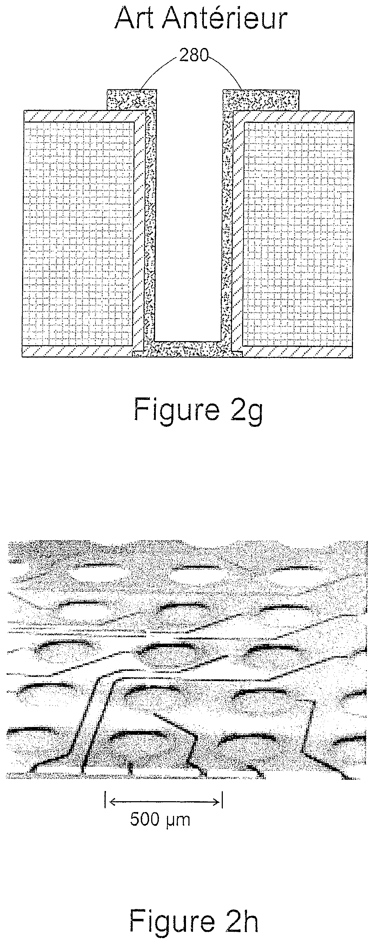

La figure 2g montre le résultat final après que l'on a procédé au retrait de la couche initiale 260 et à celles d'accrochage et de barrière de diffusion au cuivre, mentionnées précédemment (non représentées). La gravure se fait typiquement soit par une méthode plasma ou par usinage ionique, ou bien par une méthode humique (gravure chimique) ou bien encore par une combinaison des trois méthodes.

La figure 2h est une photo réalisée à l'aide d'un microscope électronique à balayage (MEB) montrant un exemple de motifs RDL définis dans un polymère photosensible avant que ne soit effectuée l'opération de métallisation par électrolyse correspondant à la figure 2e.

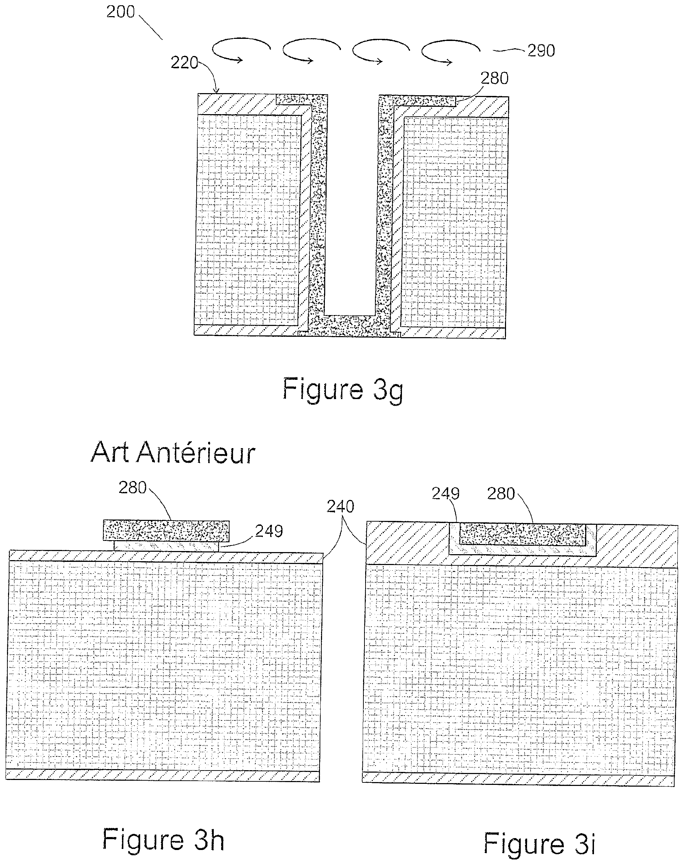

Le procédé standard décrit brièvement dans les figures 2a à 2h ci-dessus pose de nombreux problèmes :
- La chimie capable de graver la couche d'accrochage et la couche faisant barrière à la diffusion du cuivre restreint le choix des matériaux susceptibles d'être utilisé pour ces couches. Par exemple, il serait avantageux d'utiliser le nitrure de tantale (TaN) mais on ne peut pas graver ce matériau par voie humide, sélectivement par rapport au cuivre. Le nitrure de tantale est un matériau très stable, il n'existe pas de chimie capable de l'attaquer sélectivement, sans endommager les autres matériaux en présence. De même, il n'existe pas de chimie de plasma permettant de le graver dans l'industrie microélectronique. Enfin, l'usinage ionique permettrait éventuellement de le retirer mais au prix d'une attaque longue et coûteuse avec un impact important sur les couches de conducteurs et sur l'isolant situé en dessous.
- La photolithographie des motifs du niveau RDL dans une résine photosensible avec une bonne résolution est toujours compliquée par la présence du fond continu en cuivre 260 en raison d'une mauvaise adhérence de la résine qui induit des infiltrations et une perte de définition et de profil des pentes de résine.
- La présence d'un polymère de masquage pendant l'électrolyse du cuivre n'est pas compatible avec toutes les chimies disponibles. Par exemple, il n'est pas possible d'utiliser une chimie dite de « réparation », qui est parfois rendue nécessaire par la présence de cuivre en très faible quantité au fond des vias, car elle provoque la dissolution de ce polymère (chimie basique).
- Les chimies de gravure de certains matériaux et particulièrement du cuivre (Cu) et du titane (Ti) attaquent partiellement les lignes de conduction, plus particulièrement aux interfaces, ceci réduit la largeur des lignes ou leur épaisseur jusqu'à possiblement provoquer un décollement de ces dernières par surgravure latérale et consommation complète du matériau à graver à l'interface conducteur/barrière. En particulier, la gravure chimique du titane est difficile à maîtriser et se caractérise par une surgravure latérale très importante sous les lignes de cuivre.
- Le rapport de forme et la profondeur des vias font qu'il est déposé moins de cuivre au fond de ceux-ci qu'à leur sommet. La gravure du fond continu 260 de cuivre illustrée à l'étape de la figure 2g provoque l'amincissement, voire la suppression complète de la fine couche de cuivre déposé au fond des vias.
- L'état de surface du cuivre RDL est très fortement dégradé par les attaques chimiques successives. Elles induisent une forte rugosité et des difficultés pour obtenir une bonne reprise de contact dessus. Le cuivre présente aussi une plus grande propension à s'oxyder augmentant le taux de défauts ce qui affecte la fiabilité du composant.
- La topologie finale de surface, telle que révélée en figure 3h, n'est pas plane. Il est difficile d'envisager la fabrication d'un autre niveau de ligne de redistribution au dessus et d'une façon générale tout autre empilement technologique supplémentaire.
- La topologie finale nécessite l'emploi d'un polymère de passivation dont l'usage est difficile et peu répétable. De plus, ce polymère ne protège pas complètement le cuivre de l'oxygène. Un risque de diffusion du cuivre au sein du polymère existe qui est susceptible de provoquer des courts circuits entre lignes de conduction.

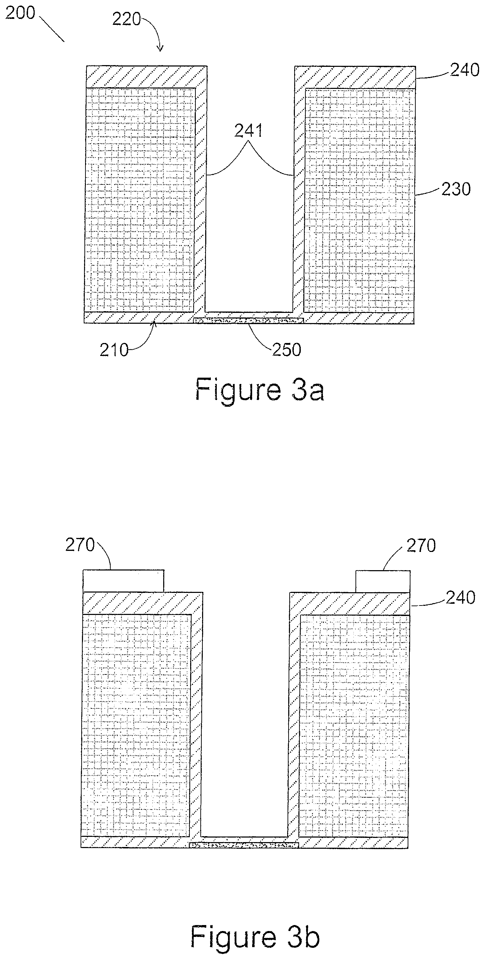

Les **figures 3a à 3g** **et** **3i** décrivent le procédé de l'invention qui apporte une solution à au moins une partie des problèmes du procédé standard de formation des vias traversants et de la couche de redistribution décrits ci-dessus.

L'invention est applicable à toutes formes et dimensions de vias. Par exemple, les vias peuvent être de section circulaire mais pas seulement. Une section polygonale est notamment aussi envisageable.

Les phases de dépôts présentées ci-après pour l'invention ne sont par défaut pas limitées à une déposition en une seule étape. Un dépôt peut être fait en plusieurs fois et la couche finale déposée peut résulter d'une pluralité de sous-couches superposées.

La figure 3a illustre le point de départ du procédé de l'invention. Elle est identique à la figure 2a du procédé standard. Elle montre l'état initial d'un TSV 200 en cours de fabrication. Il est important de rappeler que le TSV concerné par l'invention peut-être du type à grand section et/ou grande profondeur et nécessite un remplissage partiel. On y retrouve la face avant 210 à partir de laquelle les composants fonctionnels d'une puce ont été fabriqués et la face arrière 220 où l'on va réaliser le niveau de redistribution. À ce stade, comme précédemment, le TSV 200 a été gravé à travers toute l'épaisseur du substrat de la puce 230 pour définir une cavité de via et on a déposé une couche d'isolant 240, tel de l'oxyde de silicium, qui assure l'isolation électrique notamment entre les flancs 241 constituant la paroi latérale du via du TSV et le matériau semi-conducteur constituant la puce, généralement du silicium. Le substrat traversé par le TSV 200 peut, contrairement au cas illustré, présenter une structure complexe et notamment comporter une pluralité de couches de matériaux différents. Les vias sont gravés en regard de plages métalliques 250 qui ont été formées avantageusement en même temps que les interconnexions des composants réalisés sur la face avant 210 de la puce lors des opérations de « fin de ligne » (BEOL)

La figure 3b illustre l'étape suivante du procédé de l'invention où l'on procède en premier lieu à un masquage, avantageusement par photolithographie, de la couche de résine photosensible afin d'y définir les motifs 270 de la couche de redistribution. Contrairement au procédé standard, la couche de résine est déposée sur la couche d'isolant 240 avant même le dépôt de la couche métallique à partir de laquelle on va venir créer le niveau de redistribution (RDL) évitant ainsi les problèmes d'adhésion de la résine sur le cuivre mentionnés précédemment.

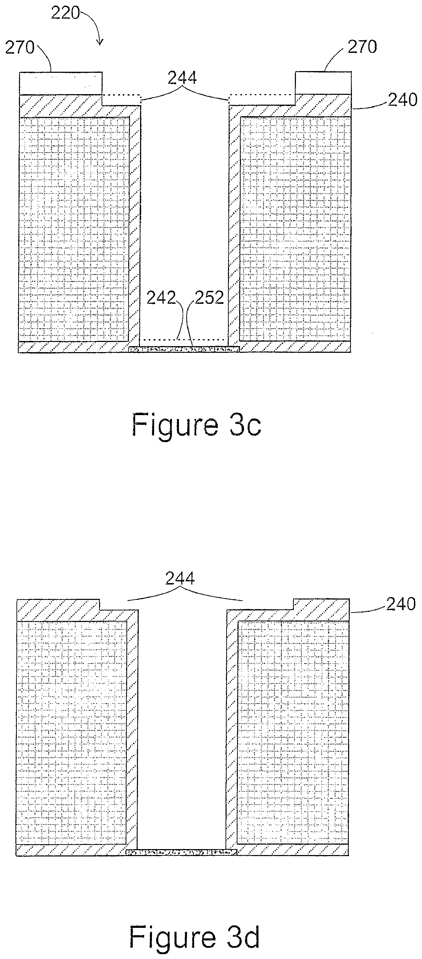

La figure 3c montre le résultat de l'étape suivante où l'on vient graver la partie de l'isolant constituant la couche 240 qui est située au fond 242 des vias, c'est-à-dire sur les plages métalliques 250. Comme précédemment, cette opération de gravure est avantageusement très anisotrope de façon à graver préférentiellement le fond 242 plutôt que les flancs 241 du via jusqu'à mettre à nu (étape repérée 252) le métal de la plage 250 pour permettre une bonne reprise de contact électrique sur celle-ci. Il y a aussi gravure de la partie de la couche d'oxyde 240 de la face arrière 220 de la puce qui n'est pas protégée par les motifs de résine 270. On grave donc cette fois les motifs de la couche de redistribution dans la couche d'oxyde 240 en y créant des dénivellations en retrait de la surface de la face arrière, de sorte à former des tranchées 244. La forme et la taille des tranchées n'est aucunement limitative de l'invention. Les tranchées s'étendent généralement suivant le plan de la face arrière de façon à produire les raccordements électriques utiles à la redistribution. Une section rectangulaire est possible pour les tranchées, suivant l'épaisseur du substrat. Leur longueur pourra être variable, selon la redistribution à opérer.

Ensuite, comme illustré par la figure 3d, on procède au retrait de la résine de masquage. Les opérations de photolithographie et de retrait de la résine après gravure peuvent se pratiquer de façon conventionnelle selon des techniques mises au point par l'industrie de la microélectronique. Le retrait de la résine de masquage laisse en place les tranchées 244 gravées dans la couche d'oxyde 240.

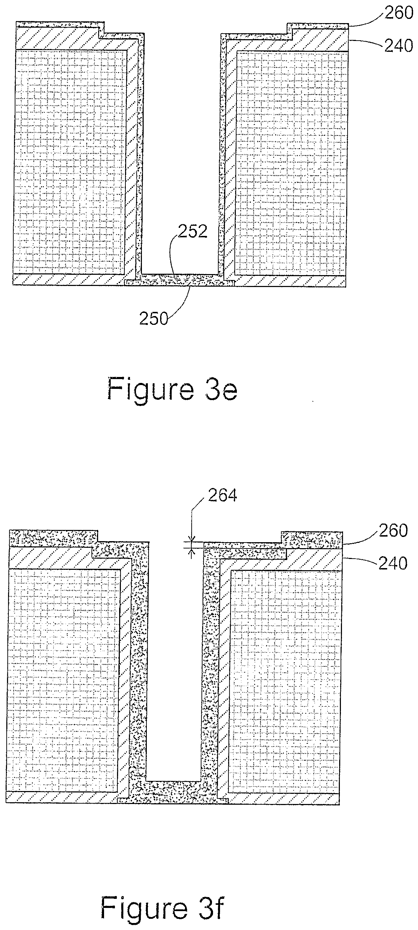

On peut alors procéder à un dépôt pleine plaque d'un fond continu métallique 260, généralement du cuivre. La figure 3e illustre le résultat de cette étape. Le dépôt de la couche 260 est préférentiellement précédé du dépôt d'une couche d'accrochage (non représentée) et d'une couche (non représentée) faisant barrière à la diffusion du cuivre dans le silicium Il s'agit par exemple de couches de nitrure de titane (TiN) ou de nitrure de tantale (TaN). Ce dernier matériau, bien meilleure barrière que le TiN peut être utilisé dans le procédé de l'invention contrairement au procédé standard. En effet, on verra après que la couche de TaN sera avantageusement retirée par un procédé de planarisation mécano-chimique emprunté au BEOL de la microélectronique et seul capable de retirer ce matériau efficacement;

À l'issue de cette étape, un bon contact électrique est établi entre la couche 260 et la plage 250 au niveau de l'interface 252.

La figure 3f illustre l'étape suivante de croissance de l'épaisseur du fond continu métallique 260. Pour ce faire, on procède au dépôt pleine plaque d'une couche de cuivre électrolytique suffisamment épaisse pour recouvrir et dépasser 264 le haut des tranchées qui ont été formées dans la couche d'oxyde. La couche de cuivre déposée doit aussi être suffisamment épaisse pour assurer une bonne conduction électrique entre le fond du via et son sommet. A titre d'exemple, il est rarement gravé plus d'un micron dans le diélectrique, afin de fabriquer les caissons RDL. Il faudra alors préférentiellement déposer au moins 3 microns de cuivre pour assurer le remplissage des caissons et une bonne planarisation mécano-chimique de retrait du surplus de cuivre en surface. On peut donc en général espérer au mieux 3 microns sur les flancs du TSV. Inversement, il est tout à fait possible de déposer beaucoup de cuivre pour permettre un tapissage des flancs du TSV plus important, comme par exemple déposer 25% du rayon du TSV et donc améliorer la conduction électrique, sans modifier l'épaisseur des lignes de RDL déterminée uniquement par la gravure du caisson dans l'oxyde. Contrairement au procédé standard, ce procédé permet donc une totale désolidarisation de l'épaisseur des lignes et de celle des flancs du TSV.

Optionnellement, dans le but de protéger le cuivre déposé, on procédera au dépôt d'une couche de passivation, par exemple du nitrure électrolytique ou un polymère de passivation. La couche de passivation peut remplir intégralement la cavité de via et notamment boucher la totalité du volume intérieur résiduel, jusqu'à l'embouchure de la tranchée débouchant sur la face 220 du substrat.

Dans le cas de l'utilisation d'un polymère de passivation, celui-ci est préférentiellement déposé de sorte à forme une pellicule superficielle, c'est-à-dire présente uniquement en surface au-dessus de la face 220. La cavité de via se trouve alors bouchée par ce dépôt sans pour autant qu'elle ne soit intégralement rempli par ledit polymère.

La figure 3g illustre un exemple de résultat final obtenu après qu'une planarisation mécanique ou mécano chimique 190 de la surface 220 a été effectuée. Typiquement, il s'agit d'une opération de polissage mécano chimique désignée par l'acronyme CMP de l'anglais « chemical mechanical polishing ». Cette opération enlève la couche de passivation précédente (si elle est présente), la couche de cuivre, là où elle excède le haut des tranchées 244, et la couche formant barrière de diffusion et la couche d'accrochage (non représentées). Elle laisse en place une couche finale formant ligne de conduction 280 (qui recouvre les motifs des tranchées 244) et s'arrête préférentiellement sur la couche d'isolant 240.

On obtient ainsi une surface parfaitement plane avec des vias 200 partiellement remplis. Il est ensuite possible de redéposer un matériau diélectrique ou passivant pour finaliser la reprise de contact, ou construire un nouveau niveau de redistribution suivant une méthode similaire ou autre. Le dépôt éventuel d'un matériau diélectrique ou passivant peut remplir complètement l'espace intérieur résiduel des vias laissé par le dépôt partiel du matériau conducteur du fond 260.

Les figures 3h et 3i montrent, pour comparaison, une coupe transversale d'une ligne de conduction du niveau RDL obtenue, respectivement, avec le procédé standard et le procédé de l'invention. On remarque sur la figure 3i que la ligne de conduction 280, généralement faite de cuivre, obtenue avec le procédé de l'invention, est complètement entourée par la couche 240 formant barrière de diffusion. Le tout est incrusté dans la couche d'oxyde 240 et forme une surface parfaitement plane.

Les avantages de la structure illustrée par les figures 3g et 3i et du procédé de l'invention sont potentiellement nombreux :
- Le procédé de l'invention n'ajoute pas d'étape supplémentaire. Son impact sur le coût total est limité à l'ajout d'une étape de polissage mécano chimique (CMP) qui est compensée par le retrait des deux étapes de gravure : celle du fond continu en cuivre et celle de la barrière de diffusion.
- Le retrait des étapes de gravure humide élimine de fait les problèmes de la surgravure latérale du cuivre et de celle de la barrière de diffusion. Ceci permet de réaliser des lignes de redistribution beaucoup plus fines, sans risque de décollement complet de ces dernières. La limitation actuelle avec le procédé standard sur la largeur des lignes de cuivre se situe à environ 10 µm. Cette technique permet des largeurs de lignes inférieures à 1 µm.
- De plus, sans gravure humide du fond continu en cuivre, le cuivre au fond des vias est préservé, ce qui évite toute étape de passivation supplémentaire. Il reste ainsi une épaisseur plus importante de conducteur, ce qui diminue la résistivité globale du via et augmente sa fiabilité, notamment s'il est ensuite rempli avec un polymère de passivation.
- Le procédé de l'invention permet d'augmenter l'épaisseur de cuivre déposé par électrolyse et d'atteindre une épaisseur spécifiée sur les flancs des vias. La surépaisseur en surface qui en résultera sera éliminée par l'étape de planarisation mécano chimique (CMP). L'épaisseur du conducteur de gainage des vias (la couche conductrice sur les flancs des vias) devient donc complètement indépendante de celle des lignes de redistribution en surface.
- Le matériau conducteur des lignes de redistribution n'est plus altéré par les étapes de gravure humide (rugosité et corrosion en surface et sur les flancs), ce qui augmente la fiabilité des connexions.
- Les lignes de conduction 280 sont parfaitement isolées entre elles (isolation latérale) avec un meilleur ancrage sur la puce. Le cuivre par exemple, est encapsulé dans ses parties basses et latérales, par un véritable matériau barrière et il est tout à fait envisageable de réaliser une passivation supérieure à l'identique.
- La surface finale est parfaitement plane. Ceci permet un remplissage des trous des vias avec un matériau polymère ou tout autre matériau diélectrique. L'obtention d'une surface parfaitement plane permet de réaliser plusieurs niveaux de RDL.
- Le choix du matériau d'accrochage et de la barrière de diffusion du cuivre est beaucoup plus large.
- Toutes les applications d'assemblage 3D qui utilisent l'approche où l'on réalise les vias traversants en dernier ou « via last » peuvent bénéficier des avantages du procédé de l'invention. C'est le cas quand on assemble des puces électroniques utilisant par exemple la technologie très répandue dite CMOS, acronyme de l'anglais « complementary metal-oxide-semiconductor » et/ou des microsystèmes électromécaniques ou MEMS après que toutes les étapes de fabrication de ces dispositifs ont été effectuées. L'invention convient notamment à la réalisation d'interposeurs 3D passifs et actifs.
- D'une façon générale, les applications qui nécessitent un haut degré d'intégration ou une haute densité des connexions peuvent bénéficier de l'invention en tirant partie : soit des règles de définition des motifs beaucoup plus fines sur les niveaux de redistribution ; soit de la surface plane qui autorise la fabrication de plusieurs niveaux d'interconnexions.

## Revendications

1. Procédé de réalisation d'au moins un via (200) dans l'épaisseur d'un substrat et d'une ligne électriquement conductrice (280) raccordée au via (200) et formée sur une face (220) du substrat, ledit procédé comportant dans l'ordre :
formation, à partir de la face (220), d'une cavité de via comportant une paroi latérale et un fond;
formation d'une couche d'isolant (240) sur la paroi latérale et le fond de la cavité et sur la face (220) du substrat ;
formation d'au moins un motif de ligne sur la face (220) du substrat, comprenant la formation d'une tranchée (244) dans une portion seulement de l'épaisseur de la couche d'isolant (240) située sur la face (220), la tranchée (244) débouchant dans la cavité de via;
remplissage, par un matériau électriquement conducteur, à la fois du motif de ligne et de la cavité du via, remplissage configuré pour ne pas remplir totalement ladite cavité;

2. Procédé selon la revendication précédente dans lequel la formation d'une tranchée (244) est opérée par gravure simultanément à un retrait par ladite gravure de la portion de la couche d'isolant (240) située sur le fond de la cavité.

3. Procédé selon la revendication précédente dans lequel la gravure est précédée d'une étape de photolithographie configurée pour délimiter un motif de tranchée.

4. Procédé selon l'une des revendications précédentes dans lequel le remplissage a une épaisseur au moins égale à une dimension en profondeur de la tranchée (244).

5. Procédé selon la revendication précédente comprenant, après remplissage, un amincissement par la face (220) du substrat jusqu'à faire disparaître le matériau électriquement conducteur en dehors de la tranchée (244).

6. Procédé selon la revendication précédente dans lequel l'amincissement est opéré par polissage mécano chimique (290).

7. Procédé selon l'une des revendications précédentes dans lequel le remplissage est effectué en deux étapes comportant une première étape de dépôt d'un fond continu conducteur (260) et une seconde étape de croissance électrolytique configurée pour remplir la au moins une tranchée (244) sans remplir totalement la cavité de via.

8. Procédé selon l'une des revendications précédentes dans lequel le remplissage est suivi par une étape de dépôt d'une couche de passivation.

9. Procédé selon la revendication précédente dans lequel la couche de passivation est en un matériau diélectrique.

10. Procédé selon l'une des deux revendications précédentes dans lequel le dépôt d'une couche de passivation est opéré de sorte à remplir intégralement la cavité de via.

11. Procédé selon l'une des revendications 8 ou 9, dans lequel la couche de passivation est en un matériau polymère et dans lequel le dépôt de la couche de passivation est opéré sur la face (220) du substrat de sorte à fermer l'embouchure de la tranchée débouchant sur la face (220) sans remplir la cavité de via.

12. Procédé selon l'une des revendications précédentes dans lequel le rapport de forme de la plus grande dimension de la section du via relativement à sa profondeur jusqu'à la tranchée (244) est compris entre 0.1 et 10

13. Procédé selon l'une des revendications précédentes dans lequel la tranchée (244) présente une première embouchure débouchant dans la cavité de via et une deuxième embouchure débouchant sur la face (220), la deuxième embouchure étant plus grande que la première embouchure.

## Patentansprüche

1. Verfahren zur Herstellung von mindestens einer Durchkontaktierung (200) in der Dicke eines Substrats, und von einer elektrisch leitfähigen Bahn (280), die mit der Durchkontaktierung (200) verbunden und auf einer Fläche (220) des Substrats gebildet ist, wobei das Verfahren der Reihe nach umfasst:
Bilden, ausgehend von der Fläche (220), eines Durchkontaktierungshohlraums, der eine Seitenwand und einen Boden umfasst;
Bilden einer Isolierschicht (240) auf der Seitenwand und dem Boden des Hohlraums und auf der Fläche (220) des Substrats;
Bilden von mindestens einem Bahnmuster auf der Fläche (220) des Substrats, umfassend das Bilden eines Grabens (244) in nur einem auf der Fläche (220) liegendem Abschnitt der Dicke der Isolierschicht (240), wobei der Graben (244) in den Durchkontaktierungshohlraum mündet;
Füllen von zugleich dem Bahnmuster und dem Durchkontaktierungshohlraum mit einem elektrisch leitfähigen Material, wobei das Füllen dafür ausgestaltet ist, den Hohlraum nicht vollständig zu füllen;

2. Verfahren nach dem vorstehenden Anspruch, wobei das Bilden eines Grabens (244) durch Ätzen gleichzeitig mit einem Entfernen, durch das Ätzen, des auf dem Boden des Hohlraums liegenden Abschnitts der Isolierschicht (240) vorgenommen wird.

3. Verfahren nach dem vorstehenden Anspruch, wobei dem Ätzen ein Photolithographie-Schritt vorangeht, der dafür ausgestaltet ist, ein Grabenmuster abzugrenzen.

4. Verfahren nach einem der vorstehenden Ansprüche, wobei die Füllung eine Dicke von mindestens gleich einer Tiefenabmessung des Grabens (244) aufweist.

5. Verfahren nach dem vorstehenden Anspruch, das nach dem Füllen ein Ausdünnen von der Fläche (220) des Substrats her umfasst, bis das elektrisch leitfähige Material außerhalb des Grabens (244) zum Verschwinden gebracht wird.

6. Verfahren nach dem vorstehenden Anspruch, wobei das Ausdünnen über chemisch-mechanisches Polieren (290) vorgenommen wird.

7. Verfahren nach einem der vorstehenden Ansprüche, wobei das Füllen in zwei Schritten ausgeführt wird, die einen ersten Schritt des Abscheidens eines durchgehenden leitfähigen Bodens (260) und einen zweiten Schritt des elektrolytischen Wachstums umfassen, der dafür ausgestaltet ist, den mindestens einen Graben (244) zu füllen, ohne den Durchkontaktierungshohlraum vollständig zu füllen.

8. Verfahren nach einem der vorstehenden Ansprüche, wobei dem Füllen ein Schritt des Abscheidens einer Passivierungsschicht folgt.

9. Verfahren nach dem vorstehenden Anspruch, wobei die Passivierungsschicht aus einem dielektrischen Material ist.

10. Verfahren nach einem der zwei vorstehenden Ansprüche, wobei das Abscheiden einer Passivierungsschicht derart vorgenommen wird, dass der Durchkontaktierungshohlraum gänzlich gefüllt wird.

11. Verfahren nach einem der Ansprüche 8 oder 9, wobei die Passivierungsschicht aus einem Polymermaterial ist, und wobei das Abscheiden der Passivierungsschicht auf der Fläche (220) des Substrats derart vorgenommen wird, dass die Einmündung des auf der Fläche (220) mündenden Grabens geschlossen wird, ohne den Durchkontaktierungshohlraum zu füllen.

12. Verfahren nach einem der vorstehenden Ansprüche, wobei das Aspektverhältnis der größten Abmessung des Querschnitts der Durchkontaktierung relativ zu ihrer Tiefe bis zum Graben (244) zwischen 0,1 und 10 beträgt

13. Verfahren nach einem der vorstehenden Ansprüche, wobei der Graben (244) eine erste Einmündung aufweist, die in den Durchkontaktierungshohlraum mündet, und eine zweite Einmündung, die auf der Fläche (220) mündet, wobei die zweite Einmündung größer ist als die erste Einmündung.

## Claims

1. Method for producing at least one via (200) in the thickness of a substrate and of an electrically conductive line (280) connected to the via (200) and formed on a face (220) of the substrate, said method comprising in order:
formation, from the face (220), of a via cavity comprising a side wall and a bottom;
formation of an insulating layer (240) on the side wall and the bottom of the cavity and on the face (220) of the substrate;
formation of at least one line pattern on the face (220) of the substrate, comprising the formation of a trench (244) in only one portion of the thickness of the insulating layer (240) located on the face (220), with the trench (244) opening into the via cavity;
filling, with an electrically conductive material, both the line pattern and the cavity of the via, filling configured to not entirely fill said cavity;

2. Method according to the preceding claim wherein the formation of a trench (244) is carried out by etching simultaneously with a removal by said etching of the portion of the insulating layer (240) located on the bottom of the cavity.

3. Method according to the preceding claim wherein the etching is preceded with a step of photolithography configured to delimit a trench pattern.

4. Method according to one of the preceding claims wherein the filling has a thickness at least equal to a dimension in depth of the trench (244).

5. Method according to the preceding claim comprising, after filling, a thinning by the face (220) of the substrate until causing the electrically conductive material to disappear outside of the trench (244).

6. Method according to the preceding claim wherein the thinning is carried out via mechanical-chemical polishing (290).

7. Method according to one of the preceding claims wherein the filling is carried out in two steps comprising a first step of deposition of a continuous conductive bottom (260) and a second step of electrolytic growth configured to fill the at least one trench (244) without entirely filling the via cavity.

8. Method according to one of the preceding claims wherein the filling is followed by a step of deposition of a passivation layer.

9. Method according to the preceding claim wherein the passivation layer is a dielectric material.

10. Method according to one of the two preceding claims wherein the deposition of a passivation layer is carried out in such a way as to completely fill the via cavity.

11. Method according to one of claims 8 or 9, wherein the passivation layer is made of a polymer material and wherein the deposition of the passivation layer is carried out on the face (220) of the substrate in such a way as to close the mouth of the trench opening onto the face (220) without filling the via cavity.

12. Method according to one of the preceding claims wherein the aspect ratio for the largest dimension of the section of the via relatively to its depth to the trench (244) is between 0.1 and 10.

13. Method according to one of the preceding claims wherein the trench (244) has a first mouth opening into the via cavity and a second mouth opening onto the face (220), with the second mouth being larger than the first mouth.
